# EUROPEAN PATENT APPLICATION

(11) **EP 3 972 399 A1**
(43) Date of publication of application: **23.03.2022**
(21) Application number: 21197223.7
(22) Date of filing: 16.09.2021
(51) Int. Cl.: H05K 7/14, H05K 7/20

(54) **NEW ENERGY VEHICLE AND ELECTRICAL CONTROL BOX THEREOF**

(30) Priority: 16.09.2020 CN 202022035133 U
(71) Applicant: Shenzhen Envicool Information Technology Co., Ltd., Shenzhen, Guangdong 518000 (CN)
(72) Inventor: LING, Bo, Guangdong, 518000 (CN); FENG, Deshu, Guangdong, 518000 (CN)
(74) Representative: Potter Clarkson

(57) **Abstract**

An electrical control box is provided according to the present application, which includes a first heat dissipation base plate and a second heat dissipation base plate. The first heat dissipation base plate and the second heat dissipation base plate may both be detachably arranged on a heat dissipation base. In the electrical control box, the first heat dissipation base plate is configured to fix the first electrical component, and the second heat dissipation base plate is configured to fix the second electrical component. A new energy vehicle is further provided according to the present application.

## Description

### FIELD

The present application relates to the technical field of new energy vehicles, in particular to a new energy vehicle and an electrical control box thereof.

### BACKGROUND

With the development of electrical control technology, requirements for integration and reliability of electrical control and electrical drive are getting higher and higher, which requires smaller size, lighter weight, higher heat dissipation efficiency, and convenient installation and maintenance. A conventional electrical control and electrical drive adopt independent modules mounted in the same position to form a functional integration, which causes inconvenience for disassembling each module during installation and maintenance, and causes the electrical control box to be large in size, heavy in weight, and high in cost.

Therefore, a technical issue to be addressed presently by those skilled in the art is to reduce the difficulty of installation and maintenance of an electrical control box, and to reduce the size of the electrical control box at the same time.

### SUMMARY

In view of this, an electrical control box is provided according to the present application, so as to reduce the difficulty of installation and maintenance of the electrical control box and reduce the size of the electrical control box; a new energy vehicle is further provided according to the present application.

In order to achieve the above objects, the following technical solutions are provided according to the present application.

An electrical control box, including a first heat dissipation base plate and a first electrical component provided on the first heat dissipation base plate, and a second heat dissipation base plate and a second electrical component provided on the second heat dissipation base plate; where
the first heat dissipation base plate and the second heat dissipation base plate are both detachably arranged on a heat dissipation base.

Preferably, in the above electrical control box, the first electrical component includes a direct current to direct current (DCDC) converter; the second electrical component includes a direct current to alternating current (DCAC) converter.

Preferably, in the above electrical control box, the heat dissipation base is a heat dissipation base made of section aluminum.

Preferably, in the above electrical control box, the first heat dissipation base plate and the second heat dissipation base plate are both heat dissipation base plates made of section aluminum.

Preferably, in the above electrical control box, a first heat conducting layer is provided between the first heat dissipation base plate and the heat dissipation base.

Preferably, in the above electrical control box, a second heat conducting layer is provided between the second heat dissipation base plate and the heat dissipation base.

Preferably, in the above electrical control box, the heat dissipation base is provided with a flange.

Preferably, in the above electrical control box, multiple heat dissipation fins extend on a side of the heat dissipation base, away from the first heat dissipation base plate and the second heat dissipation base plate.

Preferably, in the above electrical control box, a casing and a heat dissipation fan are further provided on the heat dissipation base.

A new energy vehicle includes the electrical control box as described in any one of the above.

An electrical control box is provided according to the present application, which includes a first heat dissipation base plate and a second heat dissipation base plate, where a first electrical component is provided on the first heat dissipation base plate, and a second electrical component is provided on the second heat dissipation base plate; the first heat dissipation base plate and the second heat dissipation base plate may both be detachably arranged on a heat dissipation base. In the electrical control box, the first heat dissipation base plate is configured to fix the first electrical component, and the second heat dissipation base plate is configured to fix the second electrical component. With the detachable structure between the first heat dissipation base plate and the heat dissipation base, and between the second heat dissipation base plate and the heat dissipation base, the first electrical component and the second electrical component are respectively tested and maintained, and heat generated by the first electrical component and the second electrical component are dissipated by the heat dissipation base at the same time, which reduces the space occupied by multiple electrical components in the electrical control box and improves convenience of disassembly and maintenance.

### BRIEF DESCRIPTION OF THE DRAWINGS

For more clearly illustrating embodiments of the present disclosure or the technical solutions in the conventional technology, drawings referred to for describing the embodiments or the conventional technology will be briefly described hereinafter. Apparently, drawings in the following description are only examples of the present disclosure, and for the person skilled in the art, other drawings may be obtained based on the provided drawings without any creative efforts.

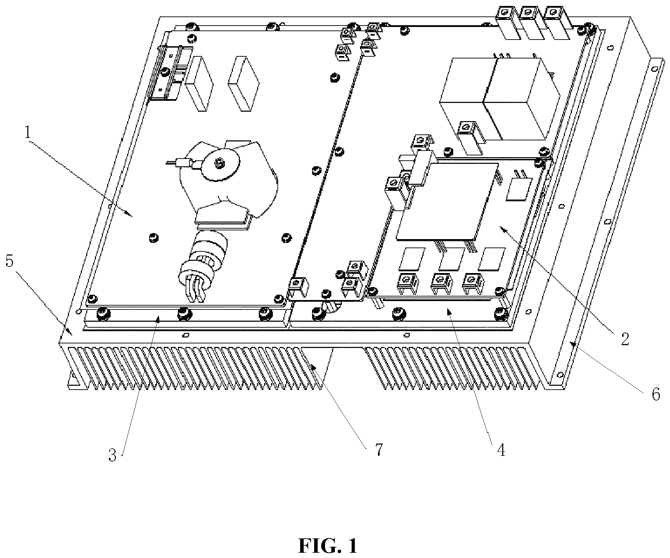

FIG. 1 is a schematic layout structural view of an electrical control box provided according to the present application.

### DETAILED DESCRIPTION OF THE EMBODIMENTS

An electrical control box is provided according to the present application, so as to reduce a space occupied by a conventional electrical control box; a new energy vehicle is further provided according to the present application.

The technical solutions according to the embodiments of the present application will be described clearly and completely as follows in conjunction with the drawings in the embodiments of the present application. It is apparent that the described embodiments are only a part of the embodiments according to the present application, rather than all of the embodiments. Based on the embodiments of the present application, all other embodiments obtained without creative efforts by those of ordinary skill in the art shall fall within the protection scope of the present application.

As shown in FIG. 1, FIG.1 is a schematic layout structural view of an electrical control box provided according to the present application.

An electrical control box is provided according to the present application, which includes a first heat dissipation base plate 3 and a second heat dissipation base plate 4, where a first electrical component is provided on the first heat dissipation base plate 3, and a second electrical component is provided on the second heat dissipation base plate 4; the first heat dissipation base plate 3 and the second heat dissipation base plate 4 may both be detachably arranged on a heat dissipation base 5. The first heat dissipation base plate 3 is configured to fix the first electrical component, and the second heat dissipation base plate 4 is configured to fix the second electrical component. Since the first heat dissipation base plate 3 and the second heat dissipation base plate 4 are both detachable relative to the heat dissipation base 5, the first electrical component and the second electrical component can be respectively tested and maintained. Moreover, heat generated by the first electrical component and the second electrical component are dissipated by the heat dissipation base 5 at the same time, which reduces the space occupied by multiple electrical components in the electrical control box and improves convenience of disassembly and maintenance.

The first electrical component and the second electrical component may be electrical elements inside the electrical control box, which may be electrical components such as a fan drive board and a filter adjustment board, etc.

Specifically, the first electrical component is a DCDC converter 1 and is fixed on the first heat dissipation base plate 3; the second electrical component is a DCAC converter 2 and is fixed on the second heat dissipation base plate 4. The first heat dissipation base plate 3 and the second heat dissipation base plate 4 may both be detachably arranged on the heat dissipation base 5. Heat generated by the first electrical component and the second electrical component are dissipated by the heat dissipation base 5 at the same time, which may effectively reduce the size of the electrical control box. The DCDC converter 1 is independently supported by the first heat dissipation base plate 3, and the DCAC converter 2 is independently supported by the second heat dissipation base plate 4. The first heat dissipation base plate 3 and the second heat dissipation base plate 4 may both form a detachable structure with the heat dissipation base 5. Specifically, multiple threaded holes are defined on the periphery of the heat dissipation base 5, and mounting holes corresponding to the threaded holes are defined on edges of the first heat dissipation base plate 3 and the second heat dissipation base plate 4. The first heat dissipation base plate 3 and the second heat dissipation base plate 4 can be mounted on the heat dissipation base 5 by screws. Of course, a mounting lug may be pre-defined on the first heat dissipation base plate 3 and the second heat dissipation base plate 4, which form a structure for mounting and disassembling by screws with the heat dissipation base 5. In case of testing or maintaining of the electrical control box, the DCDC converter 1 or the DCAC converter 2 may be independently tested and maintained and assembled, which is more convenient.

In an embodiment, a plug connection or a buckle connection may be adopted between the heat dissipation base plate 3 and the heat dissipation base 5 and between the heat dissipation base plate 4 and the heat dissipation base 5, so as to realize quick disassembly and maintenance of the first electrical component and the second electrical component.

In an embodiment of the present application, the heat dissipation base 5 can be made of section aluminum. Both the first heat dissipation base plate 3 and the second heat dissipation base plate 4 can be made of section aluminum. The section aluminum is used to manufacture the heat dissipation base 5, which carries the DCDC converter 1 and the DCAC converter 2 in one piece. The section aluminum serves as a mounting bracket for the DCDC converter 1 and the DCAC converter 2. The heat dissipation base is an integrated heat dissipation structure, which effectively reduces the size of the electrical control box.

Both the first heat dissipation base plate 3 and the second heat dissipation base plate 4 are made of materials with good heat conductivity. For example, metal heat conducting materials like copper and aluminum are used. The heat dissipation base plates transfer heat to the heat dissipation base 5. In this embodiment, the second heat dissipation base plate 4 and the first heat dissipation base plate 3 preferably use section aluminum to effectively dissipate heat while supporting the circuit board.

In an embodiment of the present application, a first heat conducting layer is provided between the first heat dissipation base plate 3 and the heat dissipation base 5; a second heat conducting layer is provided between the second heat dissipation base plate 4 and the heat dissipation base 5. The integrated heat dissipation base is used as a radiator and facilitates the mounting of bracket, which effectively reduce the size of the all-in-one electrical control box, and reduce the weight and the cost of materials. By providing the first heat conducting layer and the second heat conducting layer, it can be ensured that the heat of the first electrical component and the second electrical component is efficiently transferred to the heat dissipation base. he DCDC converter 1 and the DCAC converter 2 are respectively transitionally connected to the heat dissipation base 5 through the heat dissipation base plates. The DCDC converter 1 and DCAC converter 2 are fixed on independent heat dissipation base plates, the two converters can be independently assembled and debugged, and are convenient for later maintenance. Due to the compact structure and high production and assembly efficiency, the overall cost of the all-in-one electronic control box is reduced. Due to the reduced size, the internal space of the air conditioner is saved, which is conducive to further reducing the size of the air conditioner. The arrangement of the heat conducting layers ensures an effective heat transfer between the first heat dissipation base plate 3 and the heat dissipation base 5, and between the second heat dissipation base plate 4 and the heat dissipation base 5. Therefore, heat is efficiently transferred to the heat dissipation base. The first heat conducting layer and the second heat conducting layer may be ceramic gaskets, heat conducting silica gel, heat pipes and etc.

In an embodiment of the present application, the heat dissipation base 5 is provided with a flange 6 for mounting and fixing the heat dissipation base 5. An electrical control box structure, in which an integrated heat dissipation base 5 supports the DCDC converter 1 and the DCAC converter 2 at the same time. The installation and positioning of the electrical control box may be realized by mounting the heat dissipation base 5, and the bottom edge of the heat dissipation base is extended to dissipate the flange, which reduces the difficulty of installation, and is convenient for disassembling.

Multiple heat dissipation fins 7 extend downward from the bottom surface of the heat dissipation base 5. Heat generated by the first heat dissipation base plate 3 and the second heat dissipation base plate 4 is transferred to the heat dissipation base 5, and is fully dissipated through the heat dissipation fins 7 at the bottom, thereby improving the heat dissipation effect.

In an embodiment of the present application, an upper casing and a heat dissipation fan are further fixedly mounted on the heat dissipation base 5. The heat dissipation fan and other heat dissipation components inside the electrical control box may all be fixedly mounted on the heat dissipation base. The upper casing covers on the heat dissipation base to effectively protect internal electrical control elements.

Based on the electrical control box provided in the above embodiment, a new energy vehicle is further provided according to the present application, on which an electrical control box is provided, and the electrical control box provided on the new energy vehicle is the electrical control box provided in the above embodiment.

Since the new energy vehicle adopts the electrical control box provided according to the above embodiment, reference of beneficial effects of the new energy vehicle, which is brought by the electrical control box, may be made to the above embodiment.

The above illustration of the disclosed embodiments can enable those skilled in the art to implement or use the present application. Various modifications to the embodiments are apparent to the person skilled in the art, and the general principle herein can be implemented in other embodiments without departing from the spirit or scope of the present application. Therefore, the present application is not limited to the embodiments described herein, but should be in accordance with the broadest scope consistent with the principle and novel features disclosed herein.

## Claims

1. An electrical control box, comprising a first heat dissipation base plate and a first electrical component provided on the first heat dissipation base plate, and a second heat dissipation base plate and a second electrical component provided on the second heat dissipation base plate; wherein
at least one of the first heat dissipation base plate and the second heat dissipation base plate is detachably arranged on a heat dissipation base.

2. The electrical control box according to claim 1, wherein the first electrical component comprises a direct current to direct current (DCDC) converter; the second electrical component comprises a direct current to alternating current (DCAC) converter.

3. The electrical control box according to claim 1 or claim 2, wherein the heat dissipation base is made of section aluminum.

4. The electrical control box according to claim 1 or claim 2, wherein at least one of the first heat dissipation base plate and the second heat dissipation base plate is a heat dissipation base plate made of section aluminum.

5. The electrical control box according to claim 1, wherein a first heat conducting layer is provided between the first heat dissipation base plate and the heat dissipation base.

6. The electrical control box according to claim 1, wherein a second heat conducting layer is provided between the second heat dissipation base plate and the heat dissipation base.

7. The electrical control box according to claim 1 or claim 2, wherein the heat dissipation base is provided with a flange.

8. The electrical control box according to claim 1 or claim 2, wherein a plurality of heat dissipation fins extend on a side of the heat dissipation base, away from the first heat dissipation base plate and the second heat dissipation base plate.

9. The electrical control box according to claim 1 or claim 2, further comprising a casing, wherein the heat dissipation base is disposed in the casing.

10. The electrical control box according to claim 1, further comprising a heat dissipation fan disposed in the heat dissipation base.

11. A new energy vehicle, comprising the electrical control box according to claim 1.
